# EUROPEAN PATENT APPLICATION

(11) **EP 1 487 073 A2**
(43) Date of publication of application: **15.12.2004**
(21) Application number: 04253398.4
(22) Date of filing: 08.06.2004
(51) Int. Cl.: H01S 5/02, H01S 5/40

(54) **Mounting of a semiconductor laser device by soldering**

(30) Priority: 12.06.2003 JP 2003167816
(71) Applicant: FANUC LTD, Minamitsuru-gun, Yamanashi 401-0597 (JP)
(72) Inventor: Sakano, Tetsuro, Kawasaki-shi, Kanagawa 215-0001 (JP); Takigawa, Hiroshi, Isehara-shi, Kanagawa 259-1117 (JP); Nishikawa, Yuji, Oshino-m., Minamitsuru-g.Yamana.401-0511 (JP)
(74) Representative: Billington, Lawrence Emlyn

(57) **Abstract**

A semiconductor laser (3) has emitters (7) that are separated by LD stripes (6). Grooves (2) are formed in a mounting substrate (1) corresponding to both ends of the semiconductor laser (3). On mounting, fillets (9) are formed in the grooves (2) by molten solder, thereby reinforcing the soldering at both ends of the semiconductor laser (3) and enabling uniform bonding strength to be achieved.

## Description

### BACKGROUND OF THE INVENTION

### 1. Field of the Invention

The present invention relates to a semiconductor laser device and in particular relates to a semiconductor laser device wherein the construction of the semiconductor laser mounting substrate is improved and, in addition, the bonding strength of the solder with the semiconductor laser is improved.

### 2. Description of the Related Art

In recent years, semiconductor lasers, in particular, semiconductor laser devices wherein a one-dimensional LD array of a large number of laser diode (LD) elements arranged such that their respective light emission regions are arranged in straight-line fashion is employed as a light emission source have come to be frequently used as excitation sources of solid-state lasers such as YAG (yttrium aluminum garnet) lasers. This is chiefly because of their advantages in that the excitation efficiency is higher and the life is longer than when discharge lamps such as the conventional xenon lamps are employed as excitation sources.

As is well known, when a semiconductor laser is driven, heat is generated, causing the semiconductor laser as a whole to reach a high temperature. The method of mounting a semiconductor laser on a cooler is therefore employed in order to suppress the rise in temperature of the semiconductor laser. The semiconductor laser and the cooler must be electrically coupled and solder joints are employed for this purpose. The problem that arises with this is that, since the thermal expansion coefficients of the materials constituting the semiconductor laser and the cooler are, in general, different, residual stress is generated in the solder joints. One method of reducing this residual stress is to employ low melting point solder.

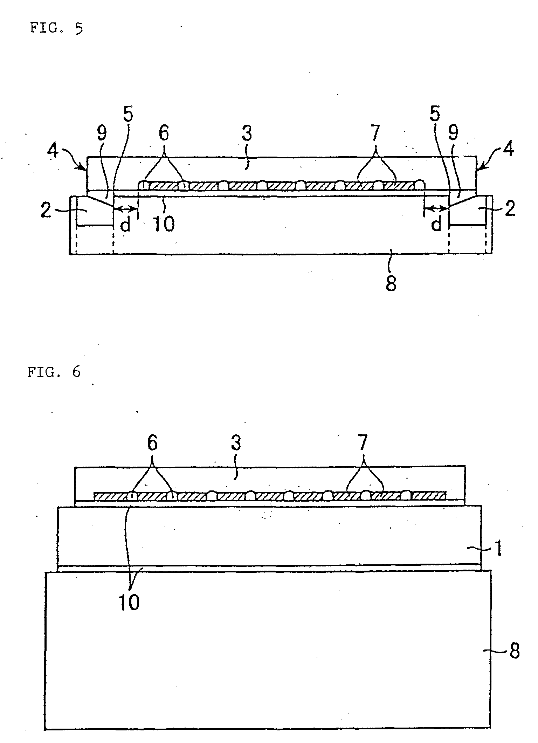

Another method is to employ a material of thermal expansion coefficient close to that of the semiconductor laser as the mounting substrate. By this method, the residual stress is moderated by allowing the mounting substrate to perform the role of a buffer material. Figure 6 is a view showing the construction of a prior art semiconductor laser device constructed using this technique. In this Figure, the mounting substrate is indicated by the reference symbol 1 and a semiconductor laser 3 having LD stripes 6 and emitters 7 are joined with this mounting substrate 1 using solder 10.

Furthermore, the mounting substrate 1 is also joined with the cooler 8 using solder 10. Most coolers 8 are provided with flow passages in their interior through which coolant is passed; however, they may also be replaced by heat sinks, which are not provided with the passages for the passage of coolant in their interior. In this specification both of these will be referred to as "coolers".

Electrical coupling between the semiconductor laser 3 and the cooler 8 is ensured by the use of such a cooler. Also, the rise in temperature of the semiconductor laser 3 is suppressed because the heat generated in the semiconductor laser 3 flows to the cooler 8 through the mounting substrate 1. Cooling of semiconductor lasers (laser diode arrays) is mentioned in the following reference:
H P Gottfried et. al. "Use of CVD diamond in high-power CO₂ lasers and laser diode arrays"; Proceedings of SPIE Vol. 3889 (2000); pp 553-563.

Of the prior art referred to above, the first problem with the use of solder of low melting point is the matter of cost. For example, although as low melting point solder, the use of indium (In) or solder of two or more elements including In may be considered, in both cases the cost is very high. Also, owing to the ease of oxidation, the operation of soldering is difficult and the reliability of the soldered condition is low.

Next, as materials for the mounting substrate whose thermal expansion coefficient is close to that of the semiconductor laser, for example silicon, silicon carbide, aluminum nitride or alumina may be considered, but these materials are also expensive. Also, since these materials are insulators, it is desirable that they should be formed with a metallic coating; however, if this is done, in addition to the material cost there is added to the cost of the metallic coating formation process, further increasing costs.

Furthermore, if the semiconductor laser and the cooler are joined by soldering or if, as shown in Figure 6, the semiconductor laser and the mounting substrate are joined by soldering, reliability of the semiconductor laser device may be lowered in that if there are regions where the joining is not uniform cooling is adversely affected and, furthermore, the laser beam is only emitted from portions where satisfactory joining has taken place. Consequently, uniform soldering is strictly required. It should be noted that "uniform soldering" in this case means "soldering that is uniform in regard to both electrical and thermal aspects". In regard to such uniform soldering, residual stress left after soldering presents an obstacle, lowering the strength of the joint and causing the development of regions that are non-uniform in electrical or thermal terms as a result of for example prolonged use or vibration. Characteristically, if the central region of the semiconductor laser and both ends thereof (the beginning and the end in the direction in which the emitters are arranged) are compared, such residual stress after soldering is greater at both ends. There is therefore a lowering in soldering strength in the vicinity of both ends compared with the middle region of the semiconductor laser if the prior art technique is employed. Such a lowering in soldering strength of course also causes a lowering in reliability of the semiconductor laser device.

### SUMMARY OF THE INVENTION

The present invention is applied to a semiconductor laser device constituted by soldering the semiconductor laser to the mounting surface of a mounting base; its basic feature is that a recess that permits inflow of solder in molten condition is provided in at least part of a portion corresponding to an end of the semiconductor laser and a fillet of solder that reinforces the mounting strength of the semiconductor laser with respect to the mounting base is formed in this recess. Preferably the semiconductor laser is arranged such that the emitter of this semiconductor laser does not overlap the recess of the mounting base and, further preferably, each of the electrode forming face, the emitter and the reflecting face constituting the resonator facing this emitter of this semiconductor laser are arranged so as not to overlap the recess of the mounting base.

As the mounting base, a mounting substrate may be adopted that is arranged interposed between the semiconductor laser and a cooler for removing the heat of this semiconductor laser. In this case, as the mounting substrate, a mounting substrate may be employed whereof at least part of the outer periphery thereof is formed by punching or cutting using a press machine, with the male mold of the press machine arranged on the semiconductor laser mounting surface side of the mounting substrate.

The recess for forming the fillet in the interior by inflow of molten solder may be formed by for example chemical etching or chemical half etching or cutting processing. Also, a solder layer may be formed beforehand on at least one of the mounting surface of the mounting base or the surface of the semiconductor laser opposite to this mounting surface, the semiconductor laser may be soldered to the mounting surface by melting this solder and the fillet may also be arranged to be formed by inflow of solder in molten condition into the recess. The preformed solder layer may be formed by for example evaporation or plating.

As the material of the solder, there may be employed for example Sn, an alloy of two or more elements including a material that forms eutectic crystals with Sn, In, or an alloy of two or more elements including In. A metallic coating may also be formed as base processing of the solder on at least the mounting surface of the mounting base. For example Ni, Pt or Cr may be employed as the material of this metallic coating.

A typical semiconductor laser mounted on the mounting base may have the form of a semiconductor laser array including a plurality of emitters, the width along the direction transverse to the plurality of emitters being for example in the range 0.5 cm to 2 cm. Preferably the plurality of emitters are each arranged in positions so as not to overlap the recesses. If the mounting base is a mounting substrate that is arranged interposed between the semiconductor laser and a cooler for removing the heat of this semiconductor laser, for example copper, a chemical compound of copper or a composite material of copper and copper oxide may be employed as the material thereof. Also, silicon, silicon carbide, aluminum nitride or alumina material may be employed as the material of the mounting substrate and a metallic coating may be formed on at least one of the side faces of this mounting substrate.

The mounting substrate may be a single substrate of a plurality of substrates formed simultaneously in the same plate member by a chemical etching step.

In this case, as the plurality of mounting substrates that are formed in the same plate member, substrates may be employed that are formed by being divided into individual substrates by punching or cutting by means of a press machine. Specifically, individual substrates, which are formed by being molded and divided into individual substrates by arranging a male mold of the press machine on the semiconductor laser mounting surface side of the plurality of mounting substrates formed in the plate member and punching or cutting at least part of the outer periphery of each mounting substrate using the press machine, may be employed as mounting substrates.

In addition, letters, numbers, symbols or patterns may be formed on the mounting substrates by the chemical etching step or chemical half etching step. Such letters, numbers, symbols or patterns may be arranged so as to make it possible to identify at what location in the aforementioned same plate member the mounting substrate was formed.

The soldering of the mounting substrate may also be effected by forming a solder layer also on the surface on the side of the cooler and simultaneously performing soldering of the mounting substrate onto this cooler and soldering of the semiconductor laser onto this mounting substrate.

The position of arrangement of the mounting substrate on the cooler is preferably such that the surface of the mounting substrate on the laser beam emission side is at a location that is further towards the inside of the cooler than the surface of the cooler on the laser beam emission side. Also, the distance between the laser beam emission surface of the semiconductor laser and the surface of the mounting substrate on the laser beam emission side can be 50 µm or less.

It should be noted that the "recesses" that are formed on the base (mounting substrate or substitute therefor, such as for example an outer covering member of the cooler) where the semiconductor laser is mounted according to the present invention are not particularly restricted as to shape and could be for example of a shape such as a groove, rebate, notch, or through-hole, so long as they permit inflow of molten solder. Also, there is no particular restriction as to their size (area occupied by the region where the recesses are formed in the surface where the mounting surface of the mounting base is provided), so long as it is possible to ensure a sufficient soldering area in the portions excluding the recesses (middle portion and the region surrounding it). Also, the recesses may be formed in a corridor shape corresponding to the overall external periphery of the mounted semiconductor laser, or may be formed so as to correspond to only a part of the external periphery of the semiconductor laser (for example two parallel sides).

According to the present invention, thanks to the above construction, a technique can be provided that ensures uniform high bonding strength between the semiconductor laser and the mounting substrate by an improved construction whereby electrical and thermal coupling of the semiconductor laser with the cooler through the mounting substrate is achieved, while yet avoiding increased costs. According to the present invention, by forming recesses such as grooves, dents, notches or through-holes in the semiconductor laser mounting surface of the mounting substrate, the strength of the soldering between the two ends of the semiconductor laser and the mounting substrate is increased and uniform soldering can be achieved, by collecting molten solder therein and forming a fillet of solder between the two ends of the semiconductor laser and the mounting substrate.

### BRIEF DESCRIPTION OF THE DRAWINGS

The above and other objects and advantages of the present invention will become apparent from the description of the following embodiments with reference to the appended drawings. In these drawings,
Figure 1 is a view given in explanation of one embodiment of the present invention, showing a plan view seen from the direction of laser-beam emission;
Figure 2A to Figure 2D are views showing an example of a mounting substrate employed in the first embodiment of the present invention and respectively show an example (Figure 2A) of a mounting substrate having a groove of U-shaped cross-section, an example (Figure 2B) wherein the recesses are formed in the form of dents, an example (Figure 2C) wherein the recesses are formed in the form of notches and an example (Figure 2D) wherein the recesses are formed in the form of through-holes;
Figure 3 is a view given in explanation of an example of a method of manufacture in which a plurality of mounting substrates are taken, shown as a plan view seen from the direction of the semiconductor laser mounting surface;
Figure 4A to Figure 4D shows diagrams of the case, in a method of manufacture in which a plurality of mounting substrates are taken, where press metal molding is employed, showing the arrangement (Figure 4A) of a male mold and female mold, the arrangement (Figure 4B) of a plate member on the female mold, the condition (Figure 4C) in which press metal molding is executed, and an individual mounting substrate (Figure 4D) obtained by press molding;
Figure 5 is a view given in explanation of a second embodiment of the present invention, showing a plan view seen from the direction of laser beam emission; and
Figure 6 is a view given in explanation of the prior art, showing a plan view seen from the direction of laser-beam emission.

### DESCRIPTION OF THE PREFERRED EMBODIMENTS

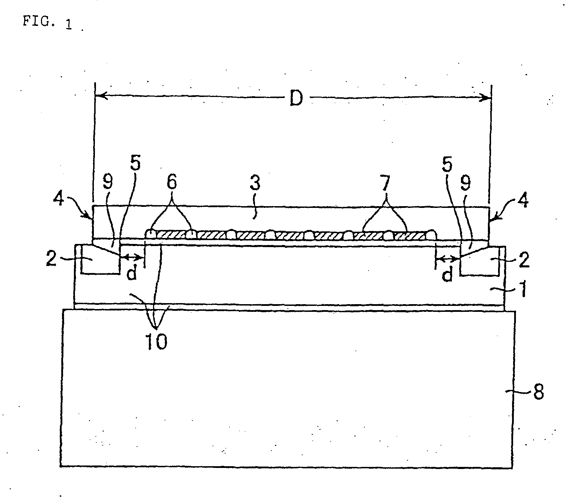

Figure 1 shows an embodiment of the present invention in plan view seen from the direction of laser-beam emission. As shown in this Figure, in this embodiment, a mounting substrate indicated by reference numeral 1 is a mounting substrate that mounts a semiconductor laser 3. The semiconductor laser 3 constitutes a one-dimensional LD array. The semiconductor laser 3 (one-dimensional LD array) comprises a plurality of emitters 7 (light-emitting portions) that are divided by means of LD stripes 6; each emitter 7 emits a laser beam in the forwards direction in the direction perpendicular to the plane of the drawing of Figure 1. D in the Figure is the width of the semiconductor laser 3 along the direction transverse to the plurality of emitters 7 and is for example in the range 0.5 cm to 2 cm.

A mounting substrate 1 is adopted having recesses constituted by grooves 2 in locations corresponding to the two ends of the semiconductor laser 3. As will be described, the recesses serve for forming solder fillets 9 by inflow of molten solder from apertures thereof on the semiconductor laser side. In this case, grooves 2 having a U-shaped cross section are shown, but there is no particular restriction to this form so long as solder fillets 9 can be formed that permit inflow of molten solder.

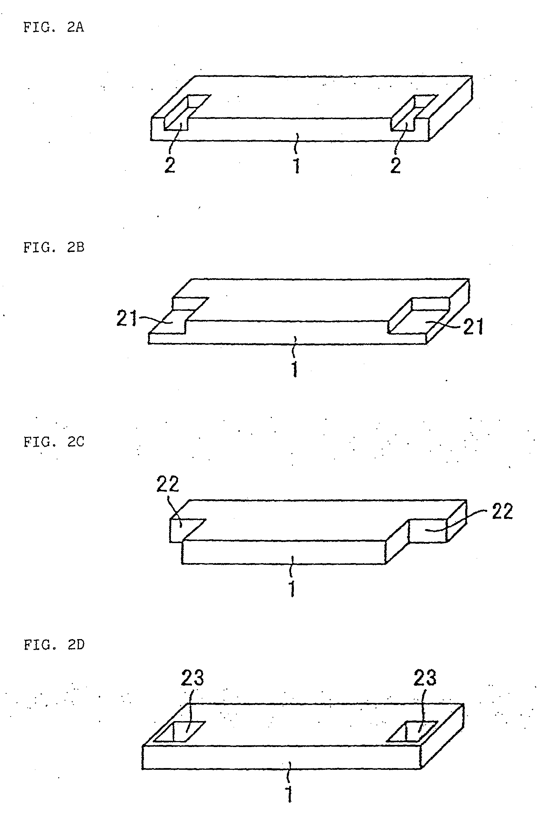

Figure 2A to Figure 2D show four examples including an example of a mounting substrate (Figure 2A) having grooves 2 of this U-shaped cross section. Figure 2B shows an example in which the recesses are formed in the form of concaves 21, Figure 2C shows an example in which the recesses are formed in the form of notches 22 and Figure 2D shows an example in which the recesses are formed in the form of through-holes 23, respectively. In the example of Figure 2A, the grooves 2 are shown in a shape produced by cutting inwards in the depth direction up to a certain point but it would be possible to adopt a shape produced by cutting to the entire length in the depth direction. In general, solder fillets 9 can be formed so long as at least a part thereof in the depth direction of the semiconductor laser 3 is arranged on a groove 2 or a recess substituting for this.

The emitters 7 of the semiconductor laser 3 are formed avoiding locations directly above the recesses constituted by the grooves 2 at both ends of the mounting substrate 1 (as described with reference to Figure 2A to Figure 2D, the term "recess" is used to include, in addition to grooves 2, for example concaves 21, notches 22 or through-holes 23); the LD stripes 6 on the outermost side are positioned in positions further inwards by a distance d (for example of the order of a few hundred µm) from the edge 5 on the inside of each recess 2 at each end. The reason why it is desirable that the emitters 7 are thus arranged in locations not overlapping with the grooves 2 of the mounting substrate 1 is that locations directly above the grooves 2 or in the vicinity thereof tend to experience insufficient cooling in spite of the fillets 9.

The mounting of the semiconductor laser 3 on the mounting substrate 1 and the mounting of the mounting substrate 1 on the outer surface of the cooler 8 are in both cases performed by soldering. Performing soldering also between the mounting substrate 1 and the cooler 8 rather than merely performing soldering between the semiconductor laser 3 and the mounting substrate 1 is advantageous in improving electrical contact and thermal contact. Also, in this case, it is advantageous if the soldering of the semiconductor laser 3 and the mounting substrate 1 and the soldering of the mounting substrate 1 and the cooler 8 are performed simultaneously, so as not to increase the number of steps.

It is convenient if the solder 10 that is employed is formed beforehand on both surfaces (the surface on the side of the semiconductor laser 3 and the surface on the side of the cooler 8) of the mounting substrate 1; this can be achieved by for example evaporation or plating. During soldering of the semiconductor laser 3 and the mounting substrate 1, some of the solder that is in a molten condition due to heating enters the interior of the grooves 2 from the vicinity of the grooves 2 (the vicinity of the electrodes at both ends of the semiconductor laser 3). The molten solder that has collected in the grooves 2 wets the inside wall of the grooves 2 and the electrodes at both ends of the semiconductor laser 3 that are arranged above the grooves 2 with the result that solder fillets 9 are formed on solidification. Thanks to this formation of fillets 9, the soldering at both ends of the semiconductor laser 3 is reinforced thereby, overall, for example making the bonding strength more uniform and making separation of the solder less likely.

Also, in particular, as shown in the example of Figure 1, if both side faces 4 of the semiconductor laser 3 are arranged exactly above the grooves 2 of the mounting substrate 1, the advantage is obtained that the possibility of solder adhering to the side faces 4 is reduced. That is, if solder adheres to the side faces 4 of the semiconductor laser 3, conduction takes place at these points, with the result that current does not flow to the emitters 7 and the laser beam is not emitted; however, if the side faces 4 are arranged directly above the grooves 2, the risk of solder adhering to the side faces 4 can be reduced.

It should be noted that, depending on the material of the solder 10 and the mounting substrate 1, the bonding strength may deteriorate with lapse of time by the formation of intermetallic chemical compounds after soldering. An example of this deterioration is the case where a material including Sn is employed for the solder 10 and a material including copper is employed for the mounting substrate 1. In order to avoid this deterioration, a coating of for example Ni, Ti, Pt or Cr may be formed on the mounting substrate 1 as base processing of the solder 10.

Flux is frequently employed in order to improve wettability by removing the oxide film at the surface of the solder during soldering. However, in a semiconductor laser device, the laser beam emitting portions (emitters 7) of the semiconductor laser 3 are in positions that are extremely close to the solder 10 (for example no more than about 10 µm), so residual amounts of flux may adhere to the laser beam emitting portions. If the emitters 7 are contaminated by residual amounts of flux, the emitted beam is obstructed, risking a lowering of output. Also, corrosion of the laser-beam emission surfaces of the semiconductor laser may cause a lowering of reliability of the semiconductor laser device. It is therefore desirable to ensure that the effect of flux residues is substantially nil by for example employing a low residue type flux.

Another method of achieving this is the technique of employing hydrogen gas when soldering; if this is adopted, the oxide film at the surface of the solder is removed by the reductive action of the hydrogen, improving wettability and hence improving reliability of soldering. There is the advantage that the effect of flux residues is eliminated, since there is no need to employ flux. In soldering the mounting substrate 1 and the cooler 8, the solder needs to wet and spread over the surface of the cooler, so, as already stated, solder is preferably applied beforehand by evaporation or plating at least to the surface of the cooler where the mounting substrate is to be mounted. However, if electrical contact and thermal contact can be ensured, soldering of the mounting substrate 1 and the cooler 8 is not necessarily essential.

Taking into consideration the cooling performance of the semiconductor laser 3, the length and arrangement of the semiconductor laser 3, the mounting substrate 1 and the cooler 8 in the depth direction are important factors. The "depth direction" means the direction of laser-beam emission (in Figure 1 this is the direction perpendicular to the plane of the drawing sheet, i.e. the direction perpendicular to the direction indicated by the width D). The length of the mounting substrate 1 in this laser-beam emission direction (depth direction) is preferably the same as the length of the semiconductor laser 3 in the depth direction, or exceeds this to some extent. Furthermore, preferably the length of the cooler 8 in the depth direction is the same as the length of the mounting substrate 1 in the depth direction or exceeds this to some extent.

Also, preferably, the surface of the mounting substrate 1 on the laser-beam emission side is arranged at a distance somewhat further inwards than the surface on the laser-beam emission side of the cooler 8. Also, preferably, the semiconductor laser 3 is arranged such that the distance between the laser-beam emission surface (light emission surface of the emitters 7) and the surface of the mounting substrate 1 on the laser-beam emission side is for example 50 µm or less.

There is a wide degree of freedom regarding the selection of the material of the mounting substrate 1 and the material of the solder. Although the solder fillets 9 must be formed within the grooves 2, there are no particular restrictions regarding the mounting substrate or solder material in order to achieve this. For example, although the reinforcing effect of the fillets 9 is then somewhat reduced by comparatively large residual stress, copper, which is inexpensive, may be employed as the material of the mounting substrate 1. Also, as the solder 10, SnPb eutectic solder, which is of excellent wettability and with which the soldering operation can be performed easily, may be employed. In this case, the reliability of the solder joints may be improved even though the cost is low. However, higher melting point solder may be employed, if wettability can be ensured.

Thus, although it is preferable to employ a copper mounting substrate and SnPb eutectic solder in view of cost aspects and ease of the soldering operation, in cases where the residual stress aspect is regarded as important, it is preferable to employ a material whose thermal expansion coefficient is close to that of the semiconductor laser for the mounting substrate and to employ a material of low melting point as the solder (so-called low melting point solder). For example, mounting substrates made of silicon, silicon carbide, aluminum nitride or alumina may be employed albeit they are more expensive than copper. However, in this case, since these are insulators, preferably conductive processing is performed on the surface.

Depending on the material of the mounting substrate, costs might be increased by the need to form the recesses (for example grooves, dents or through-holes), as will next be described, low cost can be achieved by adopting a method of manufacture in which a plurality of mounting substrates are obtained. Also, by adopting a method of manufacture in which a plurality of these mounting substrates are obtained for the manufacture of a mounting substrate made of copper, even further reduction in costs can be achieved.

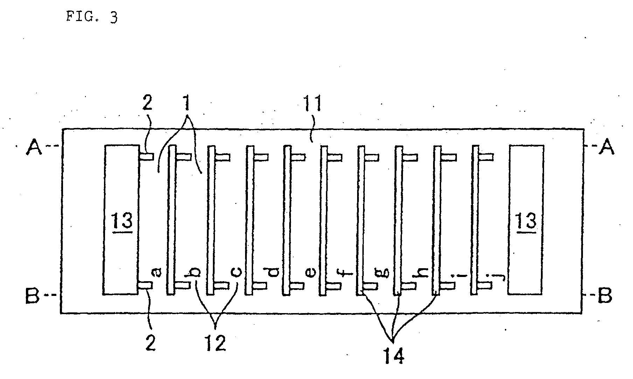

Figure 3 is a view given in explanation of an example of a method of manufacturing mounting substrates whereby a plurality of mounting substrates are obtained; in this case, an example is illustrated in which ten mounting substrates 1 are manufactured from a single plate member (for example copper sheet) 11, using a chemical etching step (or chemical half etching step). Specifically, rectangular apertures 13 on both sides of a plate member 11 and apertures 14 between adjacent mounting substrates 1 can be formed by a known chemical etching step and ten mounting substrates of the same shape and same dimensions obtained by performing cutting or punching substantially along the lines A-A and B-B.

In this process, the grooves 2 (or recesses such as dents, notches or through-holes substituting for these grooves) can also be formed simultaneously utilizing the chemical etching step (or chemical half etching step). Forming a plurality of mounting substrates in the same plate member 11 in this way is extremely advantageous in lowering manufacturing costs, enables a single mounting substrate 1 to be manufactured at low overall cost, even if an expensive material is adopted, and is even more advantageous if an inexpensive material such as copper is employed. Furthermore, it is possible to process a plurality of mounting substrates 1 at the same time by performing evaporation or plating of solder in the condition before the plate member 11 is cut.

It should be noted that it is convenient as an aid to identifying where in the plate member 11 the item originates if letters, numerals, symbols or patterns are written on the respective mounting substrates 1 when the plurality of mounting substrates 1 are formed in the plate member 11. In the example of Figure 3, ten letters of the alphabet 12 (a, b, c... j) are written on the ten mounting substrates 1 that are to be formed. Since these letters, numerals, symbols or patterns 12 are written by a chemical etching step or chemical half etching step, they can be processed during the step of forming the mounting substrate 1.

An individual mounting substrate 1 may be formed from the plate member 11 by cutting substantially along the lines A-A and B-B but the method of punching using a press machine is easy and inexpensive.

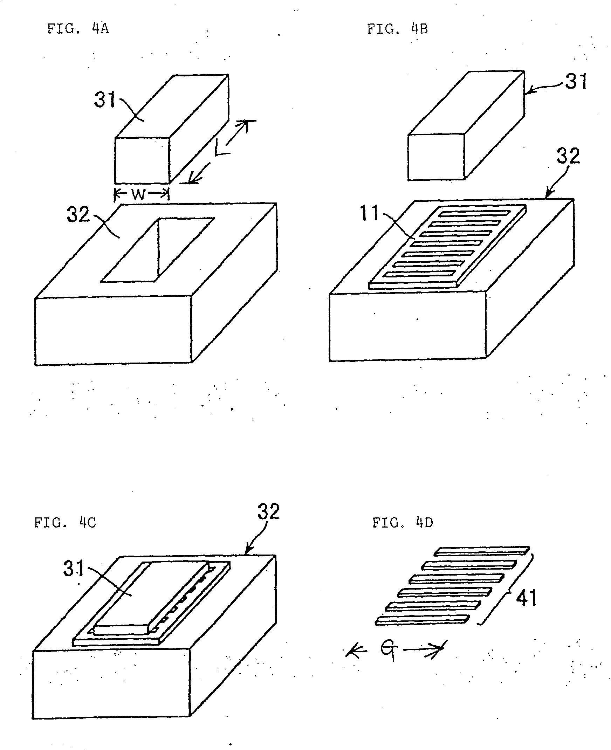

Figure 4A to Figure 4D show an example of forming an individual mounting substrate from a plate member using press punching. First of all, as shown in Figure 4A, a male mold 31 and female mold 32 are prepared. The width W of the outline of the outer periphery of the male mold 31 (corresponding to the inner peripheral edge of the female mold 32) corresponds to the distance between the lines A-A and B-B shown in Figure 3. Also, the length L of the outline of the outer periphery of the male mold 31 corresponds to the distance to the right-hand side edge of the substrate (reference symbol j) at the right-hand end from the left-hand edge of the substrate (reference symbol a) at the left-hand end shown in Figure 3.

Next, as shown in Figure 4B, the plate member 11 is arranged on the female mold 32 such that the mounting surfaces of the mounting substrates face the male mold 31 and forming is effected by cutting or punching using a press machine (not shown). Figure 4C shows the condition in which cutting or punching for forming is effected (condition in which the male mold 31 has entered the interior of the aperture of the female mold 32). After this, an individual mounting substrate 41 of the plurality of mounting substrates is obtained as shown in Figure 4D by returning the male mold 31 in the upwards direction.

It should be noted that flash may be generated at the location of punching or at the location of cutting the mounting substrate 1. If such flash is present at a soldered joint, it lowers the reliability of the soldering. In order to eliminate the effect of flash, punching or cutting may be effected in a condition with the male mold 31 of the press machine arranged at the face of the mounting substrate 1 where the semiconductor laser is mounted, so that the width G (see Figure 4D) of the mounting substrate 1 is larger than the width D (see Figure 1) of the semiconductor laser 3. This technique is adopted in the example of Figure 4 described above. Also, although, in the example of press molding described above, a plurality of mounting substrates are obtained from a single plate member 11, the same press molding technique can of course be applied even in the case where only a single mounting substrate is obtained from a single plate member.

In the above description, the mounting substrate 1 that mounts the semiconductor laser 3 is arranged interposed between the semiconductor laser 3 and the cooler 8, it will be possible to apply the concept of the present invention also in the case where the semiconductor laser 3 is directly mounted on the cooler 8. Figure 5 shows an example thereof. In this Figure 5 which is a plan view seen from the direction of beam emission, as in the case of Figure 1, the semiconductor laser 3 is a one-dimensional LD array. The semiconductor laser 3 (one-dimensional LD array) comprises a plurality of emitters 7 (light emission sections) that are divided by LD stripes 6; each emitter 7 emits a laser beam in the forwards direction in the direction perpendicular to the drawing sheet of this Figure 5.

On the upper surface of the cooler 8, in locations corresponding to the two ends of the semiconductor laser 3, there are formed recesses (grooves 2 or dents, notches or through-holes or the like substituting therefor). As described above, these grooves 2 serve to form fillets 9 of solder by inflow of molten solder from apertures on the side of the semiconductor laser and there is no particular restriction regarding their form so long as they permit inflow of molten solder and make possible the formation of solder fillets 9. The specific examples of recesses shown in Figure 2A to Figure 2D (grooves 2, or concaves 21, notches 22 and through-holes 23) can also be applied to the case in which the cooler 8 itself is employed as a mounting substrate. The broken line shown in Figure 5 shows the case where the recesses are through-holes.

The emitters 7 of the semiconductor laser 3 are formed avoiding locations directly above the grooves 2 at both ends of the semiconductor laser 3. As shown in Figure 5, the LD stripes 6 on the outermost side are positioned in positions further inwards by a distance d (for example of the order of a few hundred µm) from the edge 5 on the inside of each recess 2. The reason why it is desirable that the emitters 7 are thus arranged in locations not overlapping with the grooves 2 of the cooler (mounting substrate) 8 is that, as described with reference to the example of Figure 1, locations directly above the grooves 2 or in the vicinity thereof tend to experience insufficient cooling in spite of the fillets 9.

The mounting of the semiconductor laser 3 on the outer surface of the cooler 8 is performed by soldering. Performing soldering between the semiconductor laser 3 and the cooler 8 is extremely advantageous in improving electrical contact and thermal contact between these two.
It is convenient if the solder 10 that is employed is formed beforehand on the upper surface of the cooler 8 by for example evaporation or plating. During soldering of the semiconductor laser 3 and the cooler 8, some of the solder that is in a molten condition due to heating enters the interior of the grooves 2 from the vicinity of the grooves 2 (the vicinity of the electrodes at both ends of the semiconductor laser 3). The molten solder that has collected in the grooves 2 wets the inside wall of the grooves 2 and the electrodes at both ends of the semiconductor laser 3 that are arranged above the grooves 2 with the result that solder fillets 9 are formed on solidification. Thanks to this formation of fillets 9, the soldering at both ends of the semiconductor laser 3 is reinforced thereby, overall, for example making the bonding strength more uniform and making separation of the solder less likely.

Also, in particular, as in the case of Figure 1, if both side faces 4 of the semiconductor laser 3 are arranged exactly above the grooves 2 of the mounting substrate 1, the advantage is obtained that the possibility of solder adhering to the side faces 4 is reduced.

In the same way as described above, it should be noted that, depending on the material of the solder 10 and the cooler 8, the bonding strength may deteriorate with lapse of time by the formation of intermetallic chemical compounds after soldering. In order to avoid this deterioration, a coating of for example Ni, Ti, Pt or Cr may be formed on the upper surface of the cooler 8 as base processing of the solder 10.

Taking into consideration the cooling performance of the semiconductor laser 3, preferably the length of the cooler 8 (dimension in the direction perpendicular to the plane of Figure 5) is the same as the length of the semiconductor laser 3 in the depth direction or exceeds this to some extent. Also, preferably, the semiconductor laser 3 is arranged such that the distance between the laser-beam emission surface (light emission surface of the emitters 7) and the surface of the cooler 8 on the laser-beam emission side is for example 50 µm or less.

There is a wide degree of freedom regarding the selection of the material of the upper surface of the cooler 8 and the material of the solder. Although the solder fillets 9 must be formed within the grooves 2, there are no particular restrictions regarding the upper surface of the cooler 8 or solder material in order to achieve this. For example, although the reinforcing effect of the fillets 9 is then somewhat reduced by comparatively large residual stress, there are no particular problems if copper, which is inexpensive and commonly used, is employed as the material of the cooler 8.

In this example also, as the solder 10, SnPb eutectic solder, which is of excellent wettability and with which the soldering operation can be performed easily, may be employed. In this case, the reliability of the solder joints may be improved even though the cost is low. However, higher melting point solder may be employed, if wettability can be ensured. In cases where the residual stress aspect is regarded as important, it is preferable to employ a material of low melting point as the solder (so-called low melting point solder).

According to the present invention, recesses such as grooves, dents, notches or through-holes are formed in the semiconductor laser mounting surface of the mounting substrate, thereby enabling the formation of solder fillets between the mounting substrate and both ends of the semiconductor laser by collection of molten solder therein and so increasing the bonding strength and enabling uniform bonding strength to be obtained over the entire semiconductor laser and mounting substrate. Also, by using convenient processing techniques such as chemical etching, chemical half etching, or press processing, a plurality of mounting substrates that are employed as mounting bases can be manufactured from the same plate member, so a lowering of costs can be achieved.

## Claims

1. A semiconductor laser device comprising a semiconductor laser and a mounting base that mounts this semiconductor laser, constituted by soldering the semiconductor laser to the mounting surface of the mounting base
wherein said mounting base comprises a recess that permits inflow of solder in molten condition in at least part of a portion corresponding to an end of said semiconductor laser, and
a fillet of solder that reinforces the mounting strength of said semiconductor laser with respect to said mounting base is formed in this recess.

2. The semiconductor laser device according to claim 1 wherein said semiconductor laser is arranged such that the emitter of this semiconductor laser does not overlap said recess of said mounting base.

3. The semiconductor laser device according to claim 1 wherein said semiconductor laser is arranged such that none of the electrode forming face, the emitter and the reflecting face constituting a resonator facing this emitter of this semiconductor laser overlap said recess of said mounting base.

4. The semiconductor laser device according to claim 1 wherein said mounting base is a mounting substrate that is arranged interposed between said semiconductor laser and a cooler for removing the heat of this semiconductor laser.

5. The semiconductor laser device according to claim 4 wherein at least part of the outer periphery of said mounting substrate is formed by punching or cutting using a press machine, with the male mold of the press machine arranged on the semiconductor laser mounting surface side of said mounting substrate.

6. The semiconductor laser device according to claim 1 wherein said recess is formed by chemical etching or chemical half etching.

7. The semiconductor laser device according to claim 1 wherein said recess is formed by cutting processing.

8. The semiconductor laser device according to claim 1 wherein a solder layer is formed beforehand on at least one of said mounting surface of said mounting base or the surface of said semiconductor laser opposite to this mounting surface, said semiconductor laser is soldered to said mounting surface by melting this solder, and said fillet is formed by inflow of solder in molten condition into said recess.

9. The semiconductor laser device according to claim 8 wherein said preformed solder layer is formed by evaporation or plating.

10. The semiconductor laser device according to claim 1 wherein said solder is either Sn, an alloy of two or more elements including a material that forms eutectic crystals with Sn, In, or an alloy of two or more elements including In.

11. The semiconductor laser device according to claim 1 wherein a metallic coating is formed as base processing of said solder on at least said mounting surface of said mounting base.

12. The semiconductor laser device according to claim 11 wherein said metallic coating is an Ni, Pt or Cr coating.

13. The semiconductor laser device according to claim 1 wherein said semiconductor laser is a semiconductor laser array including a plurality of said emitters.

14. The semiconductor laser device according to claim 13 wherein said semiconductor laser array is a one-dimensional semiconductor laser array whose width along the direction transverse to said plurality of emitters is in the range 0.5 cm to 2 cm.

15. The semiconductor laser device according to claim 13 or 14 wherein each of said plurality of emitters is arranged in a position so as not to overlap said recess.

16. The semiconductor laser device according to claim 4
wherein said mounting base is made of copper, a compound of copper or a composite material of copper and copper oxide.

17. The semiconductor laser device according to claim 4 wherein said mounting base is formed by silicon, silicon carbide, aluminum nitride or alumina material and a metallic coating is formed on at least one of the side faces of this mounting substrate.

18. The semiconductor laser device according to claim 4 wherein said mounting base is a single substrate of a plurality of substrates formed simultaneously in the same plate member by a chemical etching step.

19. The semiconductor laser device according to claim 18 wherein said single substrate is formed by being molded and divided into individual substrates by arranging a male mold of the press machine on the semiconductor laser mounting surface side of the plurality of mounting substrates formed in said plate member and punching or cutting at least part of the outer periphery of each mounting substrate using the press machine.

20. The semiconductor laser device according to claim 4 wherein letters, numbers, symbols or patterns are formed on said mounting base by a chemical etching step or chemical half etching step.

21. The semiconductor laser device according to claim 18 or 19 wherein letters, numbers, symbols or patterns are formed on said mounting substrate by a chemical etching step or chemical half etching step and these characters are arranged so as to make it possible to identify at what location in said same plate member the mounting substrate was formed.

22. The semiconductor laser device according to claim 8 or 9 wherein said mounting base is a mounting substrate arranged interposed between said semiconductor laser and a cooler for removing the heat of this semiconductor laser,
a solder layer is also formed on the face of said mounting substrate on the side of said cooler and,
soldering of said mounting substrate onto this cooler and soldering of said semiconductor laser onto this mounting substrate are performed simultaneously.

23. The semiconductor laser device according to claim 1 wherein said mounting base is a mounting substrate arranged interposed between said semiconductor laser and a cooler for removing the heat of this semiconductor laser,
and said mounting substrate is arranged such that the surface of the mounting substrate on the laser beam emission side is at a location that is further towards the inside of said cooler than the surface of said cooler on the laser beam emission side.

24. The semiconductor laser device according to claim 1 wherein the distance between the laser beam emission surface of said semiconductor laser and the surface of said mounting base on the laser beam emission side is 50 µm or less.
